# EUROPÄISCHE PATENTSCHRIFT

(11) **EP 3 005 426 B1**
(45) Veröffentlichungstag und Bekanntmachung des Hinweises auf die Patenterteilung: **28.08.2019**
(21) Anmeldenummer: 14726643.1
(22) Anmeldetag: 28.05.2014
(51) Int. Cl.: H01L 31/18, H01L 31/0216

(54) **VERFAHREN ZUR HERSTELLUNG EINER SOLARZELLE**
METHOD FOR PRODUCING A SOLAR CELL
PROCÉDÉ DE FABRICATION D'UNE CELLULE SOLAIRE

(30) Priorität: 29.05.2013 DE 102013210092
(43) Veröffentlichungstag der Anmeldung: 13.04.2016
(73) Patentinhaber: International Solar Energy Research Center Konstanz E.V., 78467 Konstanz (DE)
(72) Erfinder: BOCK, Robert, 63739 Aschaffenburg (DE); BOESCKE, Tim, 93055 Regensburg (DE); SADLER, Patrick, 14471 Potsdam (DE)
(74) Vertreter: Westphal, Mussgnug & Partner Patentanwälte mbB
(86) Internationale Anmeldenummer: PCT/EP2014/061124
(87) Internationale Veröffentlichungsnummer: WO 2014/191492

(56) Entgegenhaltungen:
- WO-A1-2012/067509
- US-A1- 2008 210 950
- US-A1- 2009 283 141
- US-A1- 2011 303 266
- DIRK-HOLGER NEUHAUS ET AL: "Industrial Silicon Wafer Solar Cells", ADVANCES IN OPTOELECTRONICS, Bd. 2007, 1. Januar 2007 (2007-01-01), XP55031298, ISSN: 1687-563X, DOI: 10.1155/2007/24521

## Beschreibung

Die Erfindung betrifft ein Verfahren zur Herstellung einer Solarzelle aus kristallinem Silizium, in deren Substrat in einer ersten Oberfläche ein mittels Bor-Diffusion erzeugter Dotierungsbereich und in einer zweiten Oberfläche ein Phosphor-Dotierungsbereich vorgesehen ist. Sie betrifft des Weiteren eine Solarzelle dieses Typs.

### Stand der Technik

Solarzellen auf der Basis von mono- oder polykristallinem Halbleitermaterial, insbesondere Silizium, erbringen trotz der Entwicklung und Markteinführung neuartiger Solarzellentypen, wie Dünnschicht- und organischen Solarzellen, den weitaus größten Teil der durch photovoltaische Energieumwandlung gewonnenen elektrischen Energie. Auch bei den kristallinen Silizium-Solarzellen gab es in jüngerer Zeit wesentliche neue Entwicklungen, zu denen die Solarzellen des o. g. Typs (speziell die sog. n-PERT-Solarzellen) zählen. Im Interesse einer Optimierung der Ausbeute der photovoltaischen Energieumwandlung wurde auch der kontinuierlichen Verbesserung der Solarzellen-Vorderseiten zur Verringerung von Reflexionsverlusten große Aufmerksamkeit geschenkt.

Die Siliziumnitridabscheidung als Passivier- und Antireflexbeschichtung mittels PECVD-Verfahren ist weltweit Stand der Technik in der gesamten PV-Industrie, vgl. Armin G. Aberle, Solar Energy Materials & Solar Cells 65 (2001) 239-248; D. H. Neuhaus and A. Münzer, Advances in OptoElectronics Vol. 2007, ArticleID 24521, dx.doi.org/10.1155/2007/ 24521. Die genauen chemischen, mechanischen, elektrischen und optischen Eigenschaften der Nitridschichten hängen stark von den speziellen Prozessparametern ab. Im Allgemeinen basiert die PECVD-Chemie auf wasserstoffhaltigen Reaktanten (z. B. SiH4, NH3), und bildet daher nicht- stöchiometrische, amorphe Schichten mit einem H-Anteil bis zu 40 at.%, vgl. abermals D. H. Neuhaus and A. Münzer (siehe oben) sowie F. Duerickx and J. Szlufcik, Solar Energy Materials & Solar Cells 72 (2002) 231-246.

Der Wasserstoff im SiN:H ist verantwortlich für die hervorragenden Passiviereigenschaften des Siliziumnitrides zur Oberflächenpassivierung sowie zur Herabsetzung der Bulkrekombination während des Hochtemperaturschrittes durch Wasserstoffdiffusion zu Defektstellen und Absättigung offener Bindungen. Dabei wurden vor allem mit höher brechenden Nitriden (n>2,2@632nm) exzellente Ergebnisse erzielt, vgl. abermals F. Duerickx and J. Szlufcik (siehe oben). Höhere Brechungsindizes erreicht man durch einen höheren Silizium- bzw. Silananteil in der Schicht, gesteuert durch das NH3/SiH4-Verhältnis der Gasflüsse während des PECVD-Prozesses. Gleichzeitig steigen auch die Absorptionsverluste innerhalb der Nitridschicht, weshalb es für die Anwendung als Passivier- und Antireflexions- schicht gilt, einen Kompromiss zwischen Passivierqualität, Reflexionsminimum, und Absorptionsverlusten zu finden.

In der US 6,372,672 B1 wird für die Halbleiterindustrie ein PECVD-Siliziumnitrid als wasserstoffarmes Caplayer (<35at.%-H) beschrieben, um thermisch-induzierte Spannungsvariationen während des Annealprozesses zu reduzieren und damit das sog. "Popping" oder "Blistern" zu verhindern. Dabei wird in einem bestimmten Prozessfenster während des PECVD-Prozesses der H-Anteil so niedrig gehalten, dass sich keine Si-H-Bindungen im FTIR-Spektrum ausbilden, was dort zur gewünschten Eigenschaft führt.

Weitere Solarzellen und Verfahren zur Herstellung von Solarzellen sind beispielsweise aus der US 2009/283141 A1, der US 2008/210950 A1 und dem Artikel von Dirk-Holger Neuhaus et al. "Industrial Silicon Wafer Solar Cells", Advances in OptoElectronics, Band 2007, 1. Januar 2007 (2007-01-01), XP 55031298, ISSN 1687-563X, DOI: 10.1155/2007/24521 bekannt.

### Offenbarung der Erfindung

Mit der Erfindung wird ein Verfahren mit den Merkmalen des Anspruchs 1 bereitgestellt. Zweckmäßige Fortbildungen des Erfindungsgedankens sind Gegenstand der jeweiligen abhängigen Ansprüche.

Gemäß den Überlegungen der Erfinder soll ein wasserstoffarmes Siliziumnitrid in einem Prozessschritt zur industriellen Herstellung einer Hocheffizienzsolarzelle als Diffusionsbarriere eingesetzt werden. Wasserstoff ist, wie bereits erläutert, zur chemischen Passivierung nötig. Aktuell besteht aber das Problem, dass der Wasserstoff im anschließenden Hochtemperaturschritt ausdiffundiert und die Struktur des Nitrids derart verändert, dass keine ausreichend gute Barrierefunktion (gegen Phosphor und Bor) mehr gegeben ist, mit negativen Auswirkungen auf Dotierprofil und Schichtwiderstand. Weiterhin ist nicht mehr genügend Wasserstoff im Nitrid vorhanden, um im abschließenden Sinterschritt eine gute Oberflächenpassivierung zur Effizienzsteigerung zu erzielen.

Das neue wasserstoffarme Nitrid soll hochstöchiometrisch und damit als exzellente Diffusionsbarriere ohne Strukturveränderung durch erhöhtes thermisches Budget (>900°C) wirken. Es wird dadurch verhindert, dass es während der Bordiffusion weder zum Überkompensieren der n-Seite durch Bor(p)-Eindiffusion kommt, noch zur Ausdiffusion von Phosphoratomen aus dem Wafer heraus.

Eine hochstöchiometrische, dichte Abdeckschicht (Cap) verhindert die Eindiffusion von Bor in das zu schützende phosphordotierte Gebiet während des Bordiffusionsprozesses unter Hochtemperatur. Die Abdeckschicht verhindert gleichzeitig die Ausdiffusion von Phosphor während der Bordiffusion. Die SiN-Abdeckschicht weist dabei keine Strukturänderungen infolge Wasserstoffausdiffusion durch das thermische Budget auf.

In einer Ausführung der Erfindung wird als Abdeckschicht eine Siliziumnitridschicht mit einem Wasserstoffgehalt von 10 Atom% oder weniger, insbesondere von 5 Atom% oder weniger, aufgebracht.

In einer weiteren Ausführung ist vorgesehen, dass als Abdeckschicht eine mit Sauerstoff oder Kohlenstoff dotierte wasserstoffarme Siliziumnitridschicht aufgebracht wird.

Die aus derzeitiger Sicht bevorzugte Herstellungsart besteht darin, dass die Abdeckschicht in einem PECVD-Schritt mit Silan und Stickstoff als Prozessgas abgeschieden wird. Die Reaktion läuft gemäß folgender Reaktionsgleichung ab:

3 SiH₄ + 2 N₂ → Si₃N₄ + 6 H₂.

Eine Ausgestaltung dieser Methode besteht in der PECVD-Abscheidung des H-armen SiN mit phosphorhaltigen Precursoren (z. B. PH₃, POCl₃) und damit Abscheidung von SiN:P-Schichten. Damit ist die Abdeckschicht neben der Funktion als Diffusionsbarriere und Antireflexschicht gleichzeitig eine Dotierquelle für den Diffusionsprozess, was gleichzeitig zur Ausbildung eines Phosphor-BSF aus der Abdeckschicht heraus führt. Hiermit wird eine zusätzliche Passivierwirkung durch Feldeffekt-Passivierung erzeugt. Des Weiteren kann die SiN:P-Schicht insbesondere auch in einem Schichtstapel mit einer zweiten wasserstoffarmen Siliziumnitriddeckschicht kombiniert werden, um die Dotierquelle zu schützen.

Technische Alternativen bietet die SiNx-Abscheidung in einem PVD-Prozess durch Sputtern eines Siliziumtargets mit Stickstoffionen. Eine weitere Alternative ist die LPCVD-Abscheidung in einem Hochtemperaturofenprozess.

Eine weitere Möglichkeit, den Wasserstoffgehalt im SiN zu reduzieren, ist eine Plasmanachbehandlung der Oberfläche im Inertgasplasma (He, Ar, N₂). Dabei werden oberflächennahe N-H- und Si-H-Bindungen aufgebrochen, entstehende *dangling bonds* erzeugen Si-N-Bindungen, die gegenüber Si-Si-Bindungen energetisch bevorzugt sind, und führen so zur Wasserstoffreduktion. Die entstehenden freien Wasserstoffatome werden als molekularer Wasserstoff abgepumpt.

Die als Diffusionsbarriere wirkende Abdeckschicht kann nach dem Hochtemperaturschritt bzw. der Bordiffusion wieder entfernt und durch ein höherbrechendes Passiviernitrid ersetzt werden oder aber als Antireflexschicht/Passivierschicht erhalten bleiben. Im letzteren Falle ergibt sich eine Solarzelle mit dem erfindungsgemäßen Aufbau. Um eine allen Anforderungen genügende Passivierung der Solarzelle zu gewährleisten, kann die hier beschriebene wasserstoffarme Capschicht mit einem Passivierlayer, z. B. PECVD-SiO₂, nasschemisches SiO₂ oder thermisches SiO₂ kombiniert werden, so dass die Rückseite einen Stack aus SiO₂/Si₃N₄ bildet, bei dem das H-arme SiN-Cap bei abgestimmter Schichtdicke gleichzeitig als Antireflexbeschichtung fungiert. Insbesondere ist ein PECVD-SiO₂ für die Stackabscheidung in einer PECVD-Durchlaufanlage bestens geeignet.

### Zeichnung

Die Erfindung wird im Folgenden anhand eines Ausführungsbeispiels unter Bezugnahme auf die beigefügte, schematische Zeichnung näher erläutert.

### Ausführungsformen der Erfindung

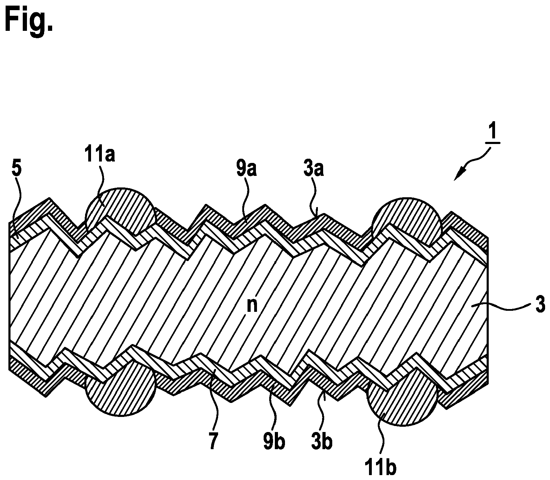

Die einzige Figur zeigt schematisch in einer Querschnittsdarstellung eine Solarzelle 1 mit einem kristallinen Siliziumsubstrat 3 vom n-Typ und einer jeweils pyramidenartig strukturierten ersten (vorderseitigen) Oberfläche 3a und zweiten (rückseitigen) Oberfläche 3b. In der ersten Oberfläche 3a ist durch Bordiffusion ein erster Dotierungsbereich (Emitterbereich) 5 gebildet, und in der zweiten Oberfläche ist durch Phosphordiffusion oder Ionenimplantation als zweiter Dotierungsbereich ein flaches Back Surface Field 7 gebildet.

Auf der ersten und zweiten Oberfläche 3a, 3b ist jeweils als Antireflexschicht eine dichte, wasserstoffarme Siliziumnitridschicht 9a bzw. 9b abgeschieden, deren Abscheidung im Verfahrensablauf nach dem Phosphordiffusionsschritt zur Erzeugung des zweiten (rückseitigen) Dotierungsbereiches und vor dem Bordiffusionsschritt zur Dotierung des ersten (vorderseitigen) Dotierungsbereiches erfolgt ist und die im letztgenannten Verfahrensschritt bezüglich des zweiten Dotierungsbereiches als Bor-Eindiffusionsbarriere und gleichzeitig als Phosphor-Ausdiffusionsbarriere wirkte. Die Antireflexschicht kann um eine zusätzliche Teilschicht aus einem Oxid (etwa Siliziumoxid) ergänzt sein, die die Passivierungseigenschaften der Schicht verbessert, in der Figur aber nicht gezeigt ist. Auf der Solarzellen-Vorderseite (ersten Oberfläche) 3a ist eine Vorderseiten-Metallisierung 11a und auf der Solarzellen-Rückseite (zweiten Oberfläche) 3b eine Rückseiten-Metallisierung 11b angebracht.

Aus derzeitiger Sicht werden in dem erwähnten PECVD-Verfahren vorteilhaft die folgenden Bereiche der Abscheidungsparameter eingestellt:

| | |
|---|---|
| • Plasmatyp | Mikrowellenplasma, remote-Beschichtung |
| • Niederdruckregime | 1..100 Pa (10^-2..10^0 mbar) |
| • Temperatur | T = 300..400°C |
| • Generatorleistung | P = 1000..2000 W |
| • Silanfluss | [SiH4] = 40..200 sccm, |
| • Stickstofffluss | [N2] = 1000..2000 sccm, |
| • evtl. geringe Mengen NH₃ zur mod. des Brechungsindex | [NH3] 20..160 sccm. |

Im Rahmen fachmännischen Handelns ergeben sich weitere Ausgestaltungen und Ausführungsformen des hier nur beispielhaft beschriebenen Verfahrens und der Vorrichtung.

## Patentansprüche

1. Verfahren zur Herstellung einer Solarzelle (1) aus kristallinem Silizium, in deren Substrat (3) in einer ersten Oberfläche (3a) ein mittels Bor-Diffusion erzeugter erster Dotierungsbereich (5) und in einer zweiten Oberfläche (3b) ein phospordotierter zweiter Dotierungsbereich (7) vorgesehen ist, wobei nach der Erzeugung des phosphordotierten zweiten Dotierungsbereichs und vor dem Schritt der Bor-Diffusion auf die zweite Oberfläche eine als Bor-Eindiffusionsbarriere und als Phosphor-Ausdiffusionsbarriere wirkende, wasserstoffarmes Siliziumnitrid mit einem Wasserstoffgehalt von 20 Atom% oder weniger aufweisende Abdeckschicht (9b) aufgebracht wird.

2. Verfahren nach Anspruch 1,
wobei als Abdeckschicht (9b) eine Siliziumnitridschicht mit einem Wasserstoffgehalt von 10 Atom% oder weniger, insbesondere von 5 Atom% oder weniger, aufgebracht wird.

3. Verfahren nach Anspruch 1,
wobei als Abdeckschicht (9b) einen Brechungsindex von weniger als 2.05, insbesondere weniger als 2.00, bei einer Wellenlänge von 589 nm aufweist.

4. Verfahren nach einem der vorangehenden Ansprüche,
wobei als Abdeckschicht (9b) eine mit Sauerstoff oder Kohlenstoff dotierte wasserstoffarme Siliziumnitridschicht aufgebracht wird.

5. Verfahren nach einem der vorangehenden Ansprüche,
wobei die Abdeckschicht (9b) in einem PECVD-Schritt mit Verbindungen aus der Silan, Ammoniak und molekularen Stickstoff umfassenden Gruppe, insbesondere Silan und Stickstoff als Prozessgas abgeschieden wird.

6. Verfahren nach Anspruch 5,
wobei die Abdeckschicht (9b) in dem PECVD-Schritt unter Einsatz eines phosphorhaltigen Precursors, etwa Monophosphan oder Phosphoroxychlorid, abgeschieden wird.

7. Verfahren nach einem der Ansprüche 1 bis 4,
wobei die Abdeckschicht (9b) in einem PVD-Prozess durch Sputtern eines Siliziumtargets mit Stickstoffionen abgeschieden wird.

8. Verfahren nach einem der Ansprüche 1 bis 4,
wobei die Abdeckschicht (9b) durch LPCVD in einem Hochtemperaturprozess abgeschieden wird.

9. Verfahren nach einem der vorangehenden Ansprüche,
wobei beim Aufbringen der Abdeckschicht (9b) nach Abscheidung einer primären Siliziumnitridschicht eine Nachbehandlung in einem Inertgasplasma zur Reduzierung des Wasserstoffgehaltes ausgeführt wird.

10. Verfahren nach einem der vorhergehenden Ansprüche, bei dem der phosphordotierte Bereich (7) durch Ionenimplantation ausgebildet wird.

11. Verfahren nach einem der Ansprüche 1 bis 9, bei dem der phosphordotierte Bereich (7) durch einen Diffusionsprozess mit POCl₃ ausgebildet wird.

12. Verfahren nach einem der vorangehenden Ansprüche,
wobei zur Ausbildung einer dauerhaften Antireflex-/Passivierungsschicht (9b) die Abdeckschicht auf der Oberfläche belassen und zusätzlich in einem PECVD- oder nasschemischen oder thermischen Schritt eine Siliziumoxidschicht ausgebildet wird.

13. Verfahren nach einem der Ansprüche 1 bis 11,
wobei die als Bor-Eindiffusionsbarriere wirkende Abdeckschicht nach dem Bor-Diffusionsschritt entfernt wird.

## Claims

1. Method for producing a solar cell (1) from crystalline silicon, in the substrate (3) of which a first doping region (5) created by means of boron diffusion is provided in a first surface (3a), and a phosphorus-doped second doping region (7) is provided in a second surface (3b), wherein after the creation of the phosphorus-doped second doping region and before the step of boron diffusion a hydrogen-poor silicon nitride with a hydrogen content of 20 atom% or less, and acting as a boron in-diffusion barrier and a phosphorus out-diffusion barrier, is applied to the second surface as a cover layer (9b).

2. Method according to claim 1, wherein a silicon nitride layer with a hydrogen content of 10 atom% or less, in particular 5 atom% or less, is applied as cover layer.

3. Method according to claim 1, wherein the cover layer (9b) has a refractive index of less than 2.05, in particular less than 2.00, at a wavelength of 589 nm.

4. Method according to any one of the preceding claims, wherein a hydrogen-poor silicon nitride layer, doped with oxygen or carbon, is applied as a cover layer (9b).

5. Method according to any one of the preceding claims, wherein the cover layer (9b) is deposited in a PECVD step with compounds from the group comprising silane, ammonia and molecular nitrogen, in particular silane and nitrogen as process gas.

6. Method according to claim 5, wherein the cover layer (9b) is deposited in the PECVD step using a phosphorus-containing precursor such as monophosphane or phosphorus oxychloride.

7. Method according to one of claims 1 to 4, wherein the cover layer (9b) is deposited in a PVD process by sputtering a silicon target with nitrogen ions.

8. Method according to any one of claims 1 to 4, wherein the cover layer (9b) is deposited by LPCVD in a high-temperature process.

9. Method according to any one of the preceding claims, wherein, during the application of the cover layer (9b), after deposition of a primary silicon nitride layer, an after-treatment is carried out in an inert gas plasma to reduce the hydrogen content.

10. Method according to any one of the preceding claims, in which the phosphorus-doped region (7) is formed by means of ion implantation.

11. Method according to any one of claims 1 to 9, in which the phosphorus-doped region (7) is configured by means of a diffusion process with POCl₃.

12. Method according to any one of the preceding claims, wherein in order to form a durable anti-reflective/passivation layer, the cover layer is left on the surface and in addition a silicon oxide layer is formed in a PECVD or wet chemical or thermal step.

13. Method according to any one of claims 1 to 11, wherein the cover layer acting as a boron in-diffusion barrier is removed after the boron diffusion step.

## Revendications

1. Procédé de fabrication d'une cellule solaire (1) en silicium cristallin dans le substrat (3) de laquelle il est prévu dans une première surface (3a) une première zone de dopage (5) obtenue par diffusion de bore et dans une seconde surface (3b) une seconde zone de dopage (7) dopée au phosphore, selon lequel après l'obtention de la seconde zone de dopage dopée au phosphore et avant l'étape de diffusion du bore, on applique sur la seconde surface une couche de revêtement (9b), agissant en tant que barrière de diffusion du bore et barrière d'exo-diffusion du phosphore renfermant du nitrure de silicium pauvre en hydrogène ayant une teneur atomique en hydrogène de 20% ou moins.

2. Procédé conforme à la revendication 1,
selon lequel en tant que couche de revêtement (9b) on applique une couche de nitrure de silicium ayant une teneur atomique en hydrogène de 10% ou moins, en particulier de 5% ou moins.

3. Procédé conforme à la revendication 1,
selon lequel la couche de revêtement (9b) a un indice de réfraction inférieur à 2,05, en particulier inférieur à 2,00 pour une longueur d'onde de 589 nm.

4. Procédé conforme à l'une des revendications précédentes,
selon lequel en tant que couche de revêtement (9b) on applique une couche de nitrure de silicium pauvre en hydrogène dopée à l'oxygène ou au carbone.

5. Procédé conforme à l'une des revendications précédentes,
selon lequel la couche de revêtement (9b) est déposée par une étape de PECVD avec des groupes renfermant des composés de silane, d'ammoniac et d'azote moléculaire, en particulier de silane et d'azote en tant que gaz de process.

6. Procédé conforme à la revendication 5,
selon lequel la couche de revêtement (9b) est déposée par une étape PECVD avec addition d'un précurseur renfermant du phosphore, en particulier du monophosphane ou de l'oxychlorure de phosphore.

7. Procédé conforme à l'une des revendications 1 à 4,
selon lequel la couche de revêtement (9b) est déposée par un procédé PVD par pulvérisation d'une cible de silicium avec des ions azote.

8. Procédé conforme à l'une des revendications 1 à 4,
selon lequel la couche de revêtement (9b) est déposée par un procédé LPCVD à haute température.

9. Procédé conforme à l'une des revendications précédentes,
selon lequel lors de l'application de la couche de revêtement (9b), après le dépôt d'une couche de nitrure de silicium primaire, on effectue un traitement ultérieur dans un plasma de gaz inerte pour réduire la teneur en hydrogène.

10. Procédé conforme à l'une des revendications précédentes,
selon lequel la zone dopée au phosphore (7) est formée par implantation d'ions.

11. Procédé conforme à l'une des revendications 1 à 9,
selon lequel la zone dopée au phosphore (7) est formée par un procédé de diffusion avec POCl₃.

12. Procédé conforme à l'une des revendications précédentes,
selon lequel pour former une couche antireflet/de passivation permanente (9b) la couche de revêtement est laissée sur la surface et en complément, une couche d'oxyde de silicium est formée par une étape PECVD ou par voie chimique humide ou thermique.

13. Procédé conforme à l'une des revendications 1 à 11,
selon lequel la couche de revêtement agissant en tant que barrière de diffusion du bore est éliminée après l'étape de diffusion du bore.
